# EUROPÄISCHE PATENTSCHRIFT

(11) **EP 0 510 423 B1**
(45) Veröffentlichungstag und Bekanntmachung des Hinweises auf die Patenterteilung: **22.01.1997**
(21) Anmeldenummer: 92106020.8
(22) Anmeldetag: 07.04.1992
(51) Int. Cl.: H04B 10/14, H01S 3/02

(54) **Optoelektronische Sendevorrichtung**
Optoelectronic transmitting device
Dispositif de transmission optoélectronique

(30) Priorität: 24.04.1991 DE 4113357
(43) Veröffentlichungstag der Anmeldung: 28.10.1992
(73) Patentinhaber: SIEMENS AKTIENGESELLSCHAFT, 80333 München (DE)
(72) Erfinder: Stein, Karl-Ulrich, Dr., W-8025 Unterhaching (DE)

(56) Entgegenhaltungen:
- EP-A- 0 196 200
- EP-A- 0 264 230
- DE-A- 3 925 189
- US-A- 4 297 653
- US-A- 4 797 895
- IBM TECHNICAL DISCLOSURE BULLETIN Bd. 32, Nr. 8A, Januar 1990, ARMONK,USA Seiten 149 - 150 'Vertically emitting diode laser with integrated front-beam monitor photodiode'

## Beschreibung

Die vorliegende Erfindung betrifft eine optoelektronische Sendevorrichtung, die insbesondere als Sende-Empfang-Wandler für Halb-Duplex-Betrieb eingesetzt werden kann.

Optoelektronische Sende-Empfang-Wandler für den Betrieb am Ende eines Lichtwellenleiters sind in der Regel für einen Vollduplex-Betrieb vorgesehen. Diese Wandler können gleichzeitig senden und empfangen. Dazu werden in der Regel für das Senden bzw. Empfangen verschiedene Wellenlängen verwendet. Die Funktionseinheiten eines derartigen optoelektronischen Sende-Empfang-Wandlers bestehen in einer Fokussierungseinrichtung am Ende des Lichtwellenleiters und daran anschließend einer Verzweigung zu einem Detektor und einem über eine Monitordiode nachgeregelten Laser, der die Trägerstrahlung für das Sendesignal liefert.

Für Datenraten bis in den Bereich von 100 und mehr Megabit pro Sekunde ist ein Halb-Duplex-Betrieb vorteilhaft, bei dem an einem Ende des Lichtwellenleiters zeitlich nacheinander gesendet bzw. empfangen wird. Dies erlaubt den Betrieb mit einer einzigen oder dicht beieinanderliegenden Wellenlängen. Bei bekannten Anordnungen, die jeweils für Voll-Duplex-Betrieb und Halb-Duplex-Betrieb anwendbar sind, ist die Verzweigung des Lichtes durch einen für die von dem Laser ausgestrahlte Strahlung halbdurchlässigen Spiegel, der das Empfangssignal in den Detektor reflektiert, gebildet. Die einzelnen Einheiten dieses Aufbaus werden diskret realisiert und in einem miniaturisierten Modul zusammenmontiert.

In der US 4,297,653 ist eine Vorrichtung beschrieben, die einen Laser und einen Detektor miteinander kombiniert. Bei dieser Vorrichtung befindet sich auf einem Substrat aus Silizium eine Laserdiode, die auf eine im Winkel von 45° geneigte Oberfläche des Substrates abstrahlt, so daß das Licht im rechten Winkel reflektiert wird. In dieser geneigten Oberfläche ist eine Fotodiode integriert, die mit einer die Reflexion verstärkenden Metallisierung versehen sein kann. Diese Fotodiode kann als Monitordiode für den Laser und/oder als Empfänger für von außen zugeführtes Licht verwendet werden. In IBM Technical Disclosure Bulletin 32, 149 bis 150 (1990) ist eine Anordnung mit einer Laserdiode beschrieben, bei der die Strahlung auf eine im Winkel von 45° zu der Ausbreitungsrichtung angeordnete Monitordiode gerichtet wird. Die Oberfläche dieser Monitordiode ist mit einer Beschichtung aus einem Dielektrikum versehen, um einen Reflexionsgrad in der Größe von 90% zu erreichen. In der US 4,797,895 ist eine Anordnung mit einer Laserdiode beschrieben, bei der das ausgesandte Licht auf eine im Winkel zu der Ausbreitungsrichtung angeordnete Monitordiode mit reflektierender Oberfläche gerichtet wird. Als mögliche Materialien für die reflektierende Oberseite dieser Monitordiode sind Al, Al₂O₃, SiO₂, Si₃N₄, Au genannt. In der EP-A-0 196 200 und in der EP-A-0 264 230 sind jeweils Anordnungen beschrieben, die eine Laserdiode und eine Fotodiode umfassen.

Aufgabe der vorliegenden Erfindung ist es, eine verbesserte optoelektronische Sendevorrichtung für alternativen Empfang im Halb-Duplex-Betrieb anzugeben, die für weitergehende Integration brauchbar ist.

Diese Aufgabe wird mit der optoelektronischen Sendevorrichtung nach Anspruch 1 gelöst. Weitere Ausgestaltungen ergeben sich aus den Unteransprüchen.

Bei der erfindungsgemäßen Vorrichtung wird die Oberfläche einer für die Regelung des Lasers vorgesehenen Monitordiode so in den Strahlengang des Lasers ausgerichtet, daß das Laserlicht in den Lichtwellenleiter reflektiert wird. Die Oberfläche der Monitordiode ist dabei so beschaffen, daß ein möglichst hoher Anteil des Laserlichtes reflektiert wird und nur ein so geringer Anteil in der Monitordiode absorbiert wird, wie für eine Regelung des Lasers über eine angeschlossene elektronische Schaltung insbesondere bei Betrieb in einem großen Temperaturbereich erforderlich ist. Die Laserstrahlung für das Senden wird also nicht wie üblich geradlinig in den Lichtwellenleiter eingekoppelt, sondern über die Monitordiode reflektiert. Die Monitordiode ist auf einem Chip gegebenenfalls zusammen mit der elektronischen Regelschaltung für den Laser integriert. Außerdem ist auf dem Chip eine Detektordiode als Empfänger für die aus dem Lichtwellenleiter geradlinig austretende Strahlung vorhanden. In einer besonderen Ausführungsform kann auch die Empfangsdiode so aufgebaut sein, daß sie bei Betrieb als Sender die Funktion einer Monitordiode übernimmt. Es braucht dann auf dem Chip nur eine Diode integriert zu sein, die im Halb-Duplex-Betrieb alternativ als Monitor für die Regelung des Lasers und als Empfangsdiode für das Detektieren der aus dem Lichtwellenleiter auftreffenden Strahlung fungiert.

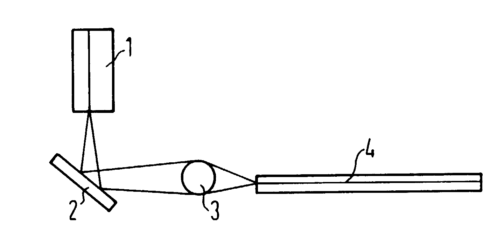

Es folgt eine Beschreibung der Anordnung anhand der Figur. Die Strahlungsrichtung des Lasers 1 ist in der Figur in rechtem Winkel zu der Ausrichtung des Lichtwellenleiters 4 angeordnet. Die Oberfläche der Monitordiode 2 reflektiert die Laserstrahlung im rechten Winkel in den Lichtwellenleiter. Es ist aber prinzipiell auch eine andere Anordnung des Lasers in spitzem oder stumpfem Winkel zum Lichtwellenleiter 4 möglich. Auf demselben Chip kann zusammen mit der Monitordiode 2 eine Empfangsdiode als Detektor integriert sein. Dabei können die Empfangsdiode und die Monitordiode räumlich getrennt nebeneinander oder übereinander im Chip angeordnet sein und gegebenenfalls die elektronischen Schaltungen für die Auswertung des detektierten Signales bzw. die Regelung des Lasers integriert sein. Es ist auch möglich, eine Diode abwechselnd als Empfangsdiode und als Monitordiode zu betreiben. In diesem Fall wird die Diode während des Empfangs in den Empfängerteil der elektronischen Schaltung und während des Sendens in den für die Regelung vorgesehenen Teil der Schaltung eingeschaltet.

Die Oberfläche der Monitordiode muß so beschaffen sein, daß ein möglichst hoher Anteil der Laserstrahlung in den Lichtwellenleiter reflektiert wird. Es muß aber genügend Strahlung für eine Ermittlung eines Kontrollsignales zur Regelung des Lasers in die Monitordiode einfallen können.

Je nach verwendeter Wellenlänge kann die Monitordiode aus Silizium, einem ternären oder einem quaternären Verbindungshalbleiter bestehen. Die teilreflektierende Eigenschaft der Oberfläche der Monitordiode kann durch reflexionsmindernde Vergütungsschichten modifiziert werden, so daß beispielsweise der Detektorwirkungsgrad zu Lasten der Strahlungsreflexion verbessert wird. Eine solche reflexionsmindernde Oberflächenbeschichtung der Monitordiode ist besonders dann von Vorteil, wenn die Monitordiode abwechselnd als Empfangsdiode betrieben wird. Dann soll von der aus dem Lichtwellenleiter 4 auf die Monitordiode 2 auftreffenden Strahlung möglichst wenig in den Laser 1 reflektiert, sondern ein möglichst hoher Anteil in der Diode absorbiert werden. Um eine diesbezügliche Optimierung für den alternativen Sende- und Empfangsbetrieb zu erreichen, kann die Abhängigkeit der Reflexionseigenschaften von der Polarisationsrichtung des Lichtes in diese Optimierung mit einbezogen werden. Bei Betrieb als Sender werden beispielsweise die Polarisationsrichtung des Lasers und der Winkel für die Reflexion an der Monitordiode so gewählt, daß nur der für die Monitorfunktion erforderliche, sehr geringe Anteil der Laserstrahlung in die Monitordiode eindringt, der größte Teil der Laserstrahlung dagegen in den Lichtwellenleiter 4 reflektiert wird. Bei Betrieb als Empfänger erreicht man die Optimierung dadurch, daß das aus dem Lichtwellenleiter austretende Licht in einer stabilen Polarisationsebene so polarisiert ist, daß ein möglichst geringer Anteil in den Laser 1 beim Auftreffen auf die Oberfläche der Monitordiode 2 reflektiert wird und praktisch die gesamte Strahlung in die Empfangsdiode gelangt. Damit kann der Wirkungsgrad der erfindungsgemäßen Vorrichtung noch wesentlich verbessert werden.

Die Aufgabe der Optimierung für den alternativen Sende- und Empfangsbetrieb kann bei Verwendung von zwei dicht beieinanderliegenden Wellenlängen für Senden und Empfangen dadurch gelöst werden, daß die reflexionsmindernde Oberflächenbeschichtung der Monitordiode nur für die Empfangswellenlänge wirkt. Für die Sendewellenlänge wird gerade noch so viel Licht in die Monitordiode durchgelassen, daß die Monitorfunktion gewährleistet ist.

Die zur Fokussierung vorgesehenen Mittel 3 bestehen z. B. in einer zwischen der Monitordiode 2 und dem Lichtwellenleiter 4 angeordneten Kugellinse. Statt der Kugellinse kann aber auch eine andere Linse, gegebenenfalls mit einem Polarisationsfilter kombiniert, verwendet werden. Eine weitere Vereinfachung der Vorrichtung wird dadurch erreicht, daß diese Fokussierung zwischen der Monitordiode und dem Lichtwellenleiter durch eine in oder auf die Monitordiode (bzw. die Empfangsdiode) integrierte holographische Oberflächenlinse bewirkt wird. Die dafür notwendigen Strukturierungen liegen, je nach Wellenlänge, im Bereich unter einem halben Mikrometer. Sie können mit den gleichen Techniken wie z. B. die DFB-Gitter bei Lasern hergestellt werden.

Die erfindungsgemäße Vorrichtung ist gegenüber den bekannten Anordnungen durch die Reduktion der Zahl der Funktionselemente wesentlich einfacher und damit zuverlässiger herstellbar.

## Patentansprüche

1. Optoelektronische Sendevorrichtung mit einem Laser (1) und mit einer Monitordiode (2), bei der der Laser (1) so angeordnet und die Oberfläche der Monitordiode (2) so beschaffen und in der Richtung der von dem Laser ausgesandten Strahlung in einem solchen Winkel dazu angeordnet ist, daß ein möglichst hoher Anteil dieser Strahlung in eine vorgegebene Richtung reflektiert wird und gleichzeitig in diese Monitordiode (2) ein so hoher Anteil dieser Strahlung einfällt, wie für eine Regelung des Lasers (1) erforderlich ist, und bei der die Monitordiode so ausgebildet ist, daß sie als Empfangsdiode für aus der vorgegebenen Richtung einfallende Strahlung betrieben werden kann,
**dadurch gekennzeichnet,** daß
die Oberfläche dieser Empfangsdiode mit einer reflexionsmindernden Schicht versehen ist und die Reflexionsgrade der reflexionsmindernden Schicht bei zwei dicht beieinanderliegenden Wellenlängen, die jeweils als Wellenlänge für den Empfang bzw. das Senden vorgesehen sind, wesentlich differieren.

2. Sendevorrichtung nach Anspruch 1,
bei der eine elektronische Schaltung, die für eine Regelung des Lasers vorgesehen ist, zusammen mit der Monitordiode auf einem Chip integriert ist.

3. Sendevorrichtung nach Anspruch 1 oder 2,
bei der eine elektronische Empfängerschaltung zusammen mit der Monitordiode auf einem Chip integriert ist.

4. Sendevorrichtung nach einem der Ansprüche 1 bis 3, bei der Mittel vorhanden sind, um die Laserstrahlung in einen in der vorgegebenen Richtung angeordneten Lichtwellenleiter (4) zu fokussieren.

5. Sendevorrichtung nach Anspruch 4,
bei der die Mittel in einer in die Oberfläche der Monitordiode integrierten holographischen Oberflächenlinse bestehen.

6. Sendevorrichtung nach einem der Ansprüche 1 bis 5, bei der Mittel vorhanden sind, um aus einem in der vorgegebenen Richtung angeordneten Lichtwellenleiter austretende Strahlung auf die Empfangsdiode zu fokussieren.

7. Sendevorrichtung nach einem der Ansprüche 1 bis 6, bei der der von der Monitordiode reflektierte Anteii der von den Laser ausgesandten Strahlung durch die Ausrichtung der Polarisationsebene dieser Strahlung vergrößert ist.

## Claims

1. Optoelectronic transmitting device having a laser (1) and having a monitor diode (2), in which device the laser (1) is arranged in such a way, and the surface of the monitor diode (2) is conditioned in such a way and arranged in the direction of the radiation emitted by the laser, at such an angle thereto, that as high a proportion as possible of this radiation is reflected in a predefined direction and, at the same time, such a high proportion of this radiation is incident into this monitor diode (2) as is required for controlling the laser (1), and in which device the monitor diode is designed in such a way that it can be operated as a receiving diode for radiation incident from the predefined direction, characterized in that
the surface of this receiving diode is provided with a reflection-reducing coating and
the reflectances of the reflection-reducing coating at two closely adjacent wavelengths, which are in each case provided as wavelengths for receiving and transmitting, respectively, differ significantly.

2. Transmitting device according to Claim 1, in which an electronic circuit, which is provided for controlling the laser, is integrated on one chip together with the monitor diode.

3. Transmitting device according to Claim 1 or 2, in which an electronic receiver circuit is integrated on one chip together with the monitor diode.

4. Transmitting device according to one of Claims 1 to 3, in which means are provided to focus the laser radiation into an optical waveguide (4) arranged in the predefined direction.

5. Transmitting device according to Claim 4, in which the means are constituted by a holographic surface lens integrated into the surface of the monitor diode.

6. Transmitting device according to one of Claims 1 to 5, in which means are provided for focusing the radiation emerging from an optical waveguide arranged in the predefined direction onto the receiving diode.

7. Transmitting device according to one of Claims 1 to 6, in which that proportion of the radiation emitted by the laser which is reflected by the monitor diode is increased by the alignment of the plane of polarization of this radiation.

## Revendications

1. Dispositif de transmission optoélectronique avec un laser (1) et avec une diode de contrôle (2) dans lequel le laser (1) est disposé de telle façon et la surface de la diode de contrôle (2) est conçue de telle façon et disposée dans la direction du rayonnement émis par le laser dans un tel angle par rapport à ceci qu'une quote-part la plus élevée possible de ce rayonnement soit réfléchie dans une direction prédéterminée et qu'en même temps une quote-part de ce rayonnement aussi élevée qu'il est nécessaire pour une régulation du laser (1) entre dans cette diode de contrôle (2) et dans lequel la diode de contrôle est conçue de telle façon qu'elle puisse fonctionner en tant que diode de réception pour un rayonnement faisant incidence en provenance de la direction prédéterminée, **caractérisé en ce que**
la surface de cette diode de réception est pourvue d'une couche atténuant la réflexion et en ce que les degrés de réflexion de la couche atténuant la réflexion, pour deux longueurs d'onde étroitement rapprochées, prévues à chaque fois comme longueur d'onde pour la réception resp. l'émission, diffèrent sensiblement.

2. Dispositif de transmission selon la revendication 1
dans lequel un montage électronique, prévu pour la régulation du laser, est intégré sur une puce, ensemble avec la diode de contrôle.

3. Dispositif de transmission selon la revendication 1 ou 2
dans lequel un montage de réception électronique est intégré sur une puce, ensemble avec la diode de contrôle.

4. Dispositif de transmission selon l'une des revendications 1 à 3
comportant des moyens pour focaliser le rayonnement du laser dans un guide d'ondes lumineuses (4) disposé dans l'une des directions prédéterminées.

5. Dispositif de transmission selon la revendication 4
dans lequel les moyens consistent en une lentille de surface holographique intégrée dans la surface de la diode de contrôle.

6. Dispositif de transmission selon l'une des revendications 1 à 5
comportant des moyens pour focaliser sur la diode de réception, le rayonnement sortant d'un guide d'ondes lumineuses disposé dans la direction prédéterminée.

7. Dispositif de transmission selon l'une des revendications 1 à 6
dans lequel la quote-part du rayonnement émis par le laser réfléchie par la diode de contrôle est agrandie par l'orientation du plan de polarisation de ce rayonnement.
